(19) **Europäisches Patentamt**
**European Patent Office**
**Office européen des brevets**

(11) **EP 4 047 379 B1**

(12) **FASCICULE DE BREVET EUROPEEN**

(45) Date de publication et mention
de la délivrance du brevet:
**08.01.2025 Bulletin 2025/02**

(21) Numéro de dépôt: **22157173.0**

(22) Date de dépôt: **17.02.2022**

(51) Classification Internationale des Brevets (IPC):
**G01R 29/08** (2006.01)     **H04B 1/7163** (2011.01)
**H03K 3/037** (2006.01)

(52) Classification Coopérative des Brevets (CPC):
**G01R 29/0892; G01R 29/0871**

(54) **UNITÉ DE DÉTECTION ET DE MESURE POUR LA DÉTECTION DE PERTURBATIONS ÉLECTROMAGNÉTIQUES, SYSTÈME DE DÉTECTION COMPRENANT UNE TELLE UNITÉ D'ANALYSE ET PROCÉDÉ D'ANALYSE**

DETEKTIONS- UND MESSEINHEIT ZUR DETEKTION VON ELEKTROMAGNETISCHEN STÖRUNGEN, DETEKTIONSSYSTEM MIT EINER SOLCHEN ANALYSEEINHEIT UND ANALYSEVERFAHREN

DETECTION AND MEASUREMENT UNIT FOR DETECTING ELECTROMAGNETIC INTERFERENCE, DETECTION SYSTEM COMPRISING SUCH AN ANALYSIS UNIT AND ANALYSIS METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.02.2021 FR 2101639**

(43) Date de publication de la demande:
**24.08.2022 Bulletin 2022/34**

(73) Titulaires:
• **Commissariat à l'Energie Atomique et aux Energies Alternatives**
**75015 Paris (FR)**
• **Inoveos**
**19100 Brive-la-Gaillarde (FR)**

(72) Inventeurs:
• **ALBUISSON, Nicolas**
**19120 VEGENNES (FR)**
• **RIBIERE-THARAUD, Nicolas**
**19100 BRIVE-LA-GAILLARDE (FR)**
• **SCHUTZ, Maxime**
**19100 BRIVE-LA-GAILLARDE (FR)**

(74) Mandataire: **Brevalex**
**Tour Trinity**
**1 B Place de la Défense**
**92400 Courbevoie (FR)**

(56) Documents cités:
EP-B1- 3 157 181        JP-A- H10 104 281
US-A- 5 495 368         US-A- 5 514 987
US-A1- 2014 080 417

EP 4 047 379 B1

## Description

## Domaine technique

L'invention concerne le domaine de la détection de perturbation électromagnétique ceci afin de prévenir les conséquences néfastes d'une telle perturbation électromagnétique.

L'invention concerne plus précisément une unité de détection et de mesure pour la détection de perturbations électromagnétiques, un système de détection de telles perturbations électromagnétiques, et un procédé de détection et de mesure.

## État de l'art antérieur

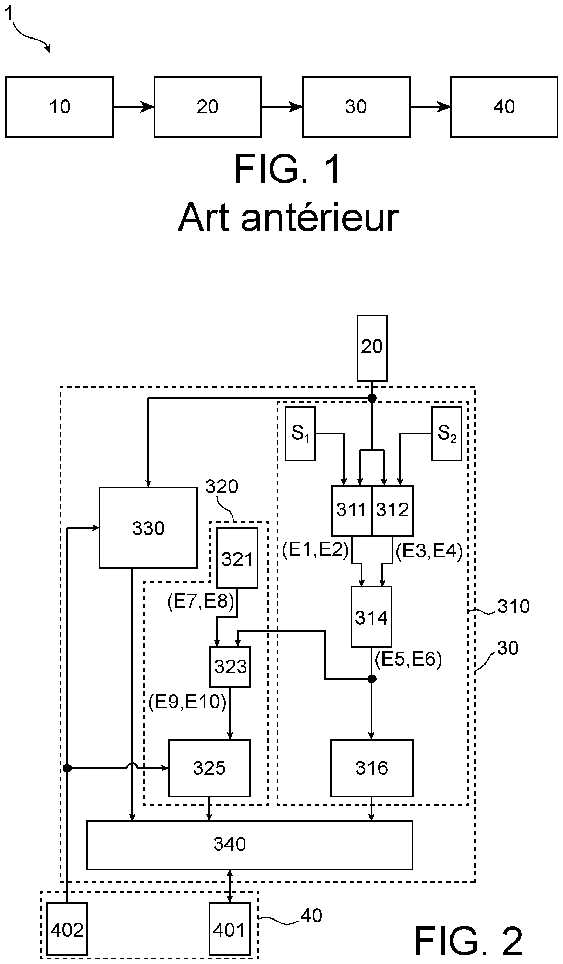

Les systèmes de détection de perturbations électromagnétiques, ou impulsions électromagnétiques, sont destinés à surveiller des installations civiles ou militaires vis-à-vis de contraintes électromagnétiques intentionnelles variées sur une large bande de fréquences, telles que par exemple les ondes électromagnétiques ultra large bande (ULB). De tels systèmes 1 comprennent, comme illustré sur la figure 1 :

- un dispositif de détection de signal ultra large bande comportant une ou plusieurs antennes 10, le dispositif de détection pouvant être équipé d'un limiteur pour protéger les composants électroniques en aval,
- une unité de traitement et de numérisation 20 du signal électromagnétique reçu par le dispositif de détection adapté pour fournir à partir du signal électromagnétique au moins un signal numérique représentatif de l'enveloppe du signal électromagnétique reçu dans au moins une bande de fréquences donnée,
- une unité de détection et de mesure 30 configurée pour recevoir l'au moins un signal numérique représentatif fourni par l'unité de traitement et pour identifier et mesurer les impulsions électromagnétiques,
- une unité d'analyse 40 pour analyser les mesures fournies par l'unité de détection et de mesure.

Dans une configuration usuelle des systèmes de détection de perturbation électromagnétique, l'unité de détection et de mesure 30 est généralement fourni au moyen d'une architecture de traitement numérique basée sur l'acquisition du ou des signaux numériques représentatifs et, après une étape de stockage, un traitement des données pour détecter et mesurer les impulsions électromagnétiques dans les données stockées. Ce type de configuration correspond notamment à celle qui est mise en oeuvre au moyen d'oscilloscope numérique et autre carte d'acquisition.

Or de telles acquisitions nécessitent une mémoire de stockage relativement importante. En effet, si on part sur une fréquence d'échantillonnage à 100 MHz et un signal présentant une fréquence de répétition relativement faible nécessitant donc une durée d'acquisition de 3s, il faut stoker 300 millions d'échantillons, soit, pour des valeurs codées en 8bits, une mémoire de 300 Mo.

De ce fait et pour une telle configuration usuelle, les unités de détection et d'analyse sont relativement complexes et nécessitent une relativement grande capacité de stockage.

Afin de simplifier ces unités de détection et d'analyse, certains documents, comme le document US 2017/0212161, proposent d'utiliser une détection simplifiée des impulsions électromagnétiques basée sur une comparaison du signal numérique représentatif fourni par le dispositif de détection de signal ultra large bande avec un simple seuil. Si une telle utilisation de détection simplifiée ouvre la possibilité d'unités de détection et d'analyse temps réel plus simples, elle n'est néanmoins pas satisfaisante. En effet, une telle solution de discrimination des impulsions électromagnétiques n'est pas fiable et peut engendrer la détection de faux positifs ou être à l'origine d'une détection moins bonne.

Ainsi, il n'existe pas à l'heure actuelle d'unité de détection et de mesure qui permette une détection et une mesure simple, rapide et fiable des impulsions électromagnétiques ceci notamment pour autoriser une analyse en temps réel du signal numérique représentatif.

On connaît également, du document US 2014/080417 A1, un dispositif de communication EHF basé sur une détection du signal EHF sur la base d'une hystérésis et, du document US 5 514 987 A, un comparateur régénératif sous la forme d'un circuit numérique.

## Exposé de l'invention

L'invention vise à résoudre les inconvénients listés ci-dessus et a ainsi pour but de fournir une unité de détection et de mesure qui autorise une détection et une mesure des impulsions électromagnétiques qui soient plus simples et rapides que celles misent en oeuvre par les unités de détection et de mesure de l'art antérieur tout en étant relativement peu coûteuse à mettre en place. À cet effet, l'invention est définie par les revendications.

L'invention concerne à cet effet une unité de détection et de mesure pour la détection de perturbation électromagnétique, l'unité de détection et de mesure étant configurée pour recevoir un signal numérique représentatif de l'enveloppe d'un signal électromagnétique reçu dans une bande de fréquences donnée dans laquelle est susceptible d'apparaître une perturbation électromagnétique,
l'unité de détection et de mesure comprenant :

- une sous-unité de détection configurée pour comparer l'amplitude du signal numérique représentatif avec un premier seuil de déclenchement et à un deuxième seuil d'arrêt, le deuxième seuil d'arrêt correspondant à une amplitude inférieure à celle correspondant au premier seuil de déclenchement, la sous-unité de détection étant en outre configurée pour détecter une impulsion électromagnétique à chaque détection du passage de l'amplitude du signal numérique représentatif par le deuxième seuil d'arrêt en front descendant après que l'amplitude du signal numérique représentatif soit passée par le premier seuil de déclenchement en front montant.

L'unité de détection et de mesure comprend un circuit logique programmable qui a été préalablement programmé pour faire office de sous-unité de détection, le circuit logique programmable étant préférentiellement un circuit logique programmable complexe, plus connu sous le sigle anglais CPLD.

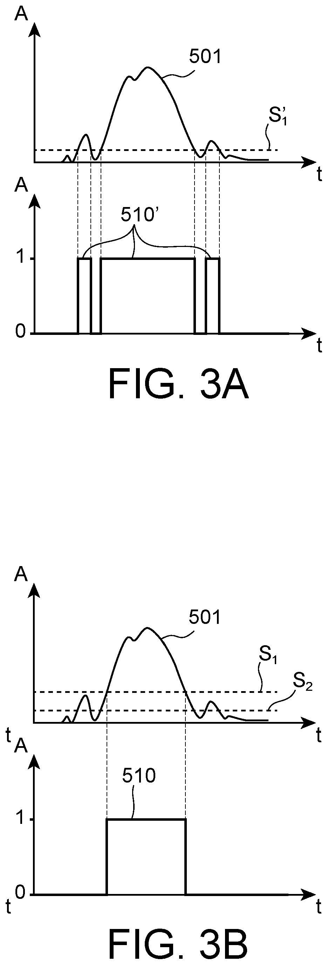

Une telle unité permet de fournir une détection d'impulsions électromagnétiques simple, puisqu'elle est basée sur une simple comparaison d'amplitude avec des valeurs seuils, tout en étant fiable de par l'utilisation d'un double seuil au lieu d'un simple seuil qui peut être à l'origine, comme cela sera discuté en lien avec les figures 3A et 3B, soit de détection de faux positifs (impulsions triplées dans l'exemple fourni) dans le cas d'un seuil trop bas, soit à une détection trop faible des impulsions (seules les impulsions présentant les amplitudes les plus importantes sont alors détectées). Ainsi, une telle simplification et fiabilité de la détection autorise le développement d'unité de détection apte à fonctionner en temps réel sans nécessiter un stockage important pour permettre un post-traitement du signal numérique représentatif.

De plus avec une telle simplicité l'invention est mise en oeuvre à partir d'un simple circuit du type circuit logique programmable et permet une détection et une mesure des impulsions électromagnétiques fiables à faible coût.

L'unité de détection et de mesure peut comprendre en outre une sous-unité de mesure de durée temporelle d'impulsion/s en communication avec la sous-unité de détection, la sous-unité de mesure temporelle d'impulsion/s étant configurée pour mesurer la durée d'impulsion/s entre les passages par l'amplitude du signal numérique représentatif du premier seuil de déclenchement en front montant et le passage du deuxième seuil d'arrêt en front descendant.

De cette manière, l'unité de détection et de mesure est apte à déterminer la durée des impulsions électromagnétiques à partir de la sous-unité de mesure temporelle d'impulsion/s ceci par une simple surveillance de la sortie de la sous-unité de détection.

La sous-unité de détection peut comprendre :

- un premier comparateur adapté pour comparer l'amplitude du signal numérique représentatif avec le premier seuil de déclenchement, le premier comparateur présentant un premier état lorsque l'amplitude du signal représentatif numérique est inférieure, voire est inférieure ou égale, au premier seuil de déclenchement et un deuxième état dans le cas contraire,

- un deuxième comparateur adapté pour comparer l'amplitude du signal numérique représentatif avec le deuxième seuil d'arrêt, le deuxième comparateur présentant un troisième état lorsque l'amplitude du signal représentatif numérique est supérieure, voire est supérieure ou égale, au deuxième seuil d'arrêt et un quatrième état dans le cas contraire,

- une première bascule présentant une première entrée de bascule connectée au premier comparateur et une deuxième entrée de bascule connectée au deuxième comparateur, la première bascule étant configurée pour passer d'un cinquième état à un sixième état lorsque le premier comparateur présente le deuxième état, et pour passer du sixième état vers le cinquième état lorsque le deuxième comparateur présente le quatrième état,

- un compteur d'impulsions connecté à une sortie de la première bascule et configuré pour compter une impulsion à chaque fois que la première bascule passe d'un état choisi parmi le sixième état et le cinquième état vers l'autre état parmi le sixième état et le cinquième état.

Une telle configuration fonctionnelle de la sous-unité de détection offre la possibilité de fournir une telle sous-unité de détection à partir d'un simple circuit logique et permet, ainsi, par exemple, de pouvoir la programmer à partir d'un circuit logique programmable. De plus, compte tenu de la simplicité du circuit logique, une telle configuration fonctionnelle autorise l'utilisation de circuits logique programmable.

On notera, de plus, que par une « comptage une impulsion à chaque fois que la première bascule première bascule passant d'un état choisi parmi le sixième état et le cinquième état vers l'autre état parmi le sixième état et le cinquième état», il doit être entendu qu'il y a le comptage d'une impulsion :

- soit uniquement lors du passage du cinquième état vers le sixième état, le cinquième état étant alors l'état choisi,

- soit uniquement lors du passage du sixième état vers le cinquième état, le sixième état étant alors l'état choisi.

On notera que, par analogie, dans le reste de ce document, à chaque fois qu'il est choisi un état parmi deux états pour un passage dudit état choisi vers l'autre état (donc non choisi), la condition est remplie uniquement lors du passage de l'état choisi vers l'autre état, l'état choisi étant une donnée prédéfinie.

La sous-unité de mesure de durée temporelle d'impulsion/s peut comprendre :

- une première horloge configurée pour présenter par alternance un septième état et un huitième état ceci avec une première fréquence d'alternance prédéfinie,

- une première porte logique présentant une première entrée de porte reliée à une sortie de la première bascule et une deuxième entrée de porte reliée à la première horloge, la première porte logique étant configurée pour présenter un neuvième état lorsque la première bascule présente le sixième état et lorsque l'horloge présente le septième état, la première porte logique présentant un dixième état le reste du temps,

- un compteur de durée d'impulsion/s connecté à une sortie de la première porte logique et configuré pour compter une pulsation de première horloge à chaque fois que la première porte logique présente le neuvième état, le nombre d'alternances comptées correspondant à la durée d'impulsion/s.

De la même façon que de la sous-unité de détection, une telle configuration fonctionnelle de la sous-unité de mesure de durée temporelle d'impulsion/s offre la possibilité de fournir une telle sous-unité de mesure de durée temporelle d'impulsion/s à partir d'un simple circuit logique et permet, ainsi, par exemple, de pouvoir la programmer à partir d'un circuit logique programmable.

L'unité de détection et de mesure peut comprendre en outre une sous-unité de mesure d'amplitude maximale d'impulsions apte à mesurer un niveau amplitude maximale atteinte par le signal numérique représentatif.

De cette manière, il est possible d'obtenir une information sur l'amplitude des impulsions électromagnétiques détectées pendant la durée de mesure considérée.

La sous-unité de mesure d'amplitude maximale d'impulsions peut comprendre une pluralité d'ensembles de comparaison comprenant chacun un troisièmes comparateur et bascule respective,

le troisième comparateur de chaque ensemble de comparaison étant adapté pour comparer l'amplitude du signal numérique représentatif avec un troisième seuil de déclenchement respectif qui est distinct des troisième seuils des autres troisièmes comparateur, ledit troisième comparateur présentant un onzième état lorsque l'amplitude du signal représentatif numérique est inférieure, voire est inférieure ou égale, au troisième seuil de déclenchement correspondant et un douzième état dans le cas contraire,

la troisième bascule de chaque ensemble de comparaison présentant une troisième entrée de bascule connectée au troisième comparateur dudit ensemble de comparaison, ladite troisième bascule étant configurée pour passer d'un treizième état à un quatorzième état lorsque le troisième comparateur dudit ensemble de comparaison présente le douzième état,

les ensembles de comparaison étant configurés pour que les troisièmes seuils de déclenchement des troisièmes comparateurs soient répartis sur une plage d'amplitudes attendues pour le signal numérique représentatif.

Une telle configuration fonctionnelle de La sous-unité de mesure d'amplitude maximale d'impulsions offre la possibilité de fournir une telle sous-unité à partir d'un simple circuit logique et permet, ainsi, par exemple, de pouvoir la programmer à partir d'un circuit logique programmable.

L'unité de détection et de mesure peut comprendre une sous-unité de mesure d'une période de répétition des impulsions électromagnétiques.

Une telle sous-unité de mesure de période permet d'estimer une fréquence de répétition ces impulsions électromagnétiques et ainsi mieux identifier les risques liés à ces impulsions électromagnétiques.

La sous-unité de mesure de fréquence de répétition des impulsions électromagnétiques peut comprendre :

- un diviseur de fréquence configuré pour basculer entre un quinzième état et seizième état à chaque passage de la première bascule à un état donné parmi le cinquième état et le sixième état,

- un compteur de nombre de double périodes connecté à une sortie de du diviseur de fréquence et configuré pour compter une double période à chaque fois que le diviseur de fréquence passe d'un état choisi parmi le quinzième état et le seizième état à l'autre état parmi le quinzième état et le seizième état,

- une deuxième horloge configurée pour présenter par alternance un dix-septième état et un dix-huitième état ceci avec une deuxième fréquence d'alternance prédéfinie,

- une deuxième porte logique présentant une troisième entrée de porte reliée à une sortie du diviseur de fréquence et une quatrième entrée de porte reliée à la deuxième horloge, la deuxième porte logique étant configurée pour présenter un dix-neuvième état lorsque le diviseur de fréquence présente le quinzième état et lorsque la deuxième horloge présente le dix-septième état, la porte logique présentant un vingtième état le reste du temps,

- un compteur de durée de périodes connecté à une sortie deuxième porte logique et configuré pour compter une pulsation de deuxième horloge à chaque fois que le diviseur de fréquence passe d'un état choisi parmi le quinzième état et le seizième état à l'autre état parmi le quinzième état et le seizième état.

Une telle configuration fonctionnelle de la sous-unité de mesure de fréquence de répétition des impulsions électromagnétique offre, de la même manière que les autres sous-unités, la possibilité de fournir une telle sous-unité à partir d'un simple circuit logique et permet, ainsi, par exemple, de pouvoir la programmer à partir d'un circuit logique programmable.

L'unité de détection et de mesure peut comprendre une mémoire tampon configuré pour récupérer compteur de durée de périodes à chaque passage du diviseur de fréquence du seizième état vers le quinzième état.

La sous-unité de détection peut être configurée pour recevoir un signal de mise à zéro et pour réaliser, lors de la réception de ce signal de mise à zéro, une fourniture d'un nombre d'impulsions électromagnétiques détectées depuis une précédente mise à zéro et une réinitialisation à zéro d'un comptage du nombre d'impulsions électromagnétiques.

La sous-unité de détection, la sous-unité de mesure de durée temporelle d'impulsion/s, la sous-unité de mesure d'amplitude maximale d'impulsions et la sous-unité de mesure d'une période de répétition des impulsions électromagnétiques peuvent être configurées pour recevoir un signal de mise à zéro et pour réaliser, lors de la réception de ce signal de mise à zéro :

- une fourniture de respectivement un nombre d'impulsions électromagnétiques détectées, une durée temporelle d'impulsion/s, une amplitude maximale d'impulsions mesurée, et une période de répétition des impulsions électromagnétiques mesurée depuis une précédente mise à zéro et
- une réinitialisation à zéro d'un comptage du nombre d'impulsions électromagnétiques.

L'invention concerne en outre un système de détection de perturbation électromagnétique comprenant :

- une unité de réception de signaux électromagnétique configurée pour recevoir au moins une partie du rayonnement électromagnétique auquel est soumis le système de détection sous la forme d'un signal électromagnétique reçu dans une bande de fréquences donnée et pour fournir un signal numérique représentatif de l'enveloppe dudit signal électromagnétique,
- une unité de détection et de mesure telle que définie ci-dessus.

Un tel système de détection présente les avantages associés à l'unité de détection et de mesure selon l'invention qu'il comprend.

L'invention concerne en outre un procédé d'analyse pour la détection de perturbation électromagnétique mis en oeuvre à l'aide d'une unité de détection et de mesure telle que définie ci-dessus, le procédé comprenant les étapes de :

- réception d'un signal numérique représentatif de l'enveloppe d'un signal électromagnétique reçu dans une bande de fréquences donnée dans laquelle est susceptible d'apparaître une perturbation électromagnétique,

- comparaison de l'amplitude du signal numérique représentatif avec un premier seuil de déclenchement et un deuxième seuil d'arrêt, le deuxième seuil d'arrêt correspondant à une amplitude inférieure à celle correspondant au premier seuil de déclenchement,
- détection d'une impulsion électromagnétique à chaque détection du passage de l'amplitude du signal numérique représentatif par le deuxième seuil en front descendant après que l'amplitude du signal numérique représentatif soit passée par le premier seuil en front montant.

Un tel procédé peut être mis en oeuvre avec une unité de détection et de meure selon l'invention et ainsi bénéficier des avantages qui y sont associés.

Le procédé d'analyse pour la détection de perturbation électromagnétique peut comprendre en outre les étapes de :

- fourniture d'un premier signal d'horloge présentant une première fréquence d'alternance prédéfinie,
- modulation du premier signal d'horloge avec un signal de détection d'impulsions électromagnétiques fourni lors de l'étape de détection d'une impulsion électromagnétique,
- comptage du nombre de signal d'horloge restant après modulation avec le signal de détection d'impulsions électromagnétiques.

Un tel procédé permet une mesure simple de la durée des impulsions électromagnétiques.

**Brève description des dessins**

La présente invention sera mieux comprise à la lecture de la description d'exemples de réalisation, donnés à titre purement indicatif et nullement limitatif, en faisant référence aux dessins annexés sur lesquels :

La figure 1 illustre les principaux éléments d'un système de détection de perturbations électromagnétiques qu'il soit de l'art antérieur ou selon l'invention,
La figure 2 illustre un schéma fonctionnel d'une unité de détection et de mesure de perturbations électromagnétiques selon l'invention,
La figure 3A illustre le principe de détection d'impulsions électromagnétiques mis en oeuvre dans le cadre des procédés de l'art antérieur,
La figure 3B illustre le principe de détection d'impulsions électromagnétiques basé sur l'utilisation de deux valeurs seuils conformément à l'invention,
La figure 4 illustre le principe de détermination de la durée des impulsions électromagnétique mis en oeuvre dans le cadre de l'invention,
La figure 5 illustre un schéma fonctionnel d'une sous-unité de mesure d'une période de répétition des impulsions électromagnétiques selon un deuxième mode de réalisation de l'invention,

La figure 6 illustre graphiquement le principe de mesure d'une fréquence de répétition des impulsions électromagnétiques tel qu'il est mis en oeuvre dans le cadre du deuxième mode de réalisation de l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## Description des modes de réalisation

La figure 1 illustre les principaux éléments d'un système de détection de perturbation électromagnétiques qu'il soit de l'art antérieur ou selon l'invention, utilisé pour la détection de perturbations électromagnétiques.
Ainsi un tel système de détection 1 comprend :

- un dispositif de détection de signal ultra large bande comportant une ou plusieurs antennes 10, le dispositif de détection pouvant être équipé d'un limiteur pour protéger les composants électronique en aval,
- une unité de traitement et de numérisation 20 du signal électromagnétique reçu par le dispositif de détection adapté pour fournir à partir du signal électromagnétique au moins un signal numérique représentatif de l'enveloppe du signal électromagnétique reçu dans au moins une bande de fréquences donnée,
- une unité de détection et de mesure 30 configurée pour recevoir l'au moins un signal numérique représentatif fourni par l'unité de traitement et pour identifier et mesurer les impulsions électromagnétiques,
- une unité d'analyse 40 pour analyser les mesures fournies par l'unité de détection et de mesure.

Le dispositif de détection de signal ultra large bande 10 et l'unité de traitement et de numérisation 20 selon le premier mode de réalisation de l'invention peuvent être conforme à ceux mis en oeuvre dans le cadre de l'art antérieur. En particulier, le dispositif de détection de signal ultra large bande 10 et l'unité de traitement et de numérisation 20 peuvent être conforme à l'enseignement du document EP 3157181 B1.
On notera que selon une configuration standard et utilisée dans l'art antérieur et notamment dans le document EP 3157181 B1, l'unité de traitement et de numérisation 20 est adaptée pour fournir plusieurs signaux numériques représentatifs de l'enveloppe du signal électromagnétique reçu dans des bandes de fréquences distincts et le système de détection 1 comprend pour chacune des bandes de fréquences une unité de détection et de mesure 30 distincte adaptée pour traiter le signal numérique représentatif correspondant à ladite bande de fréquences. Ainsi, si, pour des raisons de simplification, il n'est décrit ci-après qu'une seule et une unique unité de détection et de mesure, il est parfaitement envisageable, sans que l'on sorte du cadre de l'invention, que le système de détection 1 comporte une pluralité d'unités de détection et de mesure 30.
Conformément à la figure 2, selon l'invention, l'unité de détection et de mesure 30 comprend :

- une sous-unité de détection 310 configurée pour comparer l'amplitude du signal numérique représentatif 501, tel que celui illustré sur les figures 3A et 3B, avec un premier seuil de déclenchement S1 et à un deuxième seuil d'arrêt S2, le deuxième seuil d'arrêt S2 correspondant à une amplitude inférieure à celle correspondant au premier seuil de déclenchement S1, la sous-unité de détection 310 étant en outre configurée pour détecter une impulsion électromagnétique à chaque détection du passage de l'amplitude du signal numérique représentatif par le deuxième seuil d'arrêt S2 en front descendant après que l'amplitude du signal numérique représentatif soit passée par le premier seuil de déclenchement S1 en front montant,
- une sous-unité de mesure de durée temporelle d'impulsion/s 320 en communication avec la sous-unité de détection 310, la sous-unité de mesure temporelle d'impulsion/s 320 étant configurée pour mesurer la durée d'impulsion/s entre les passages par l'amplitude du signal numérique représentatif 501 du premier seuil de déclenchement S1 en front montant et le passage du deuxième seuil d'arrêt S2 en front descendant,
- une sous-unité de mesure d'amplitude maximale d'impulsions 330 apte à mesurer un niveau amplitude maximale atteinte par le signal numérique représentatif 501,
- une sous-unité d'interface 340 pour faire interface entre les autres sous-unités 310, 320, 330 de l'unité de détection et de mesure 30 et l'unité d'analyse 40.

Une telle unité de détection et de mesure 30, selon une possibilité particulièrement avantageuse de l'invention, peut comprendre un circuit logique programmable, non figuré, qui a été préalablement programmé pour faire office d'au moins une partie, voire l'ensemble, des sous-unités 310, 320, 330, 340 de l'unité de détection et de mesure 30, le circuit logique programmable étant préférentiellement un circuit logique programmable complexe, plus connu sous le sigle anglais CPLD. Selon cette possibilité, le circuit logique programmable présente des sous-parties programmées chacune pour faire office d'une sous-unité 310, 320, 330, 340 respective de l'unité de détection et de mesure 30. Bien entendu, dans le cas où le système comprend une pluralité d'unité de détection et de mesure 30, celles-ci peuvent mutualiser un seul circuit logique programmable pour fournir tout ou partie des sous-unités 310, 320, 330, 340 de ces unités de détection et de mesure 30 ou chacune comprendre leur circuit logique programmable respectif ou encore une mutualisation partiel des circuits logique programmable entre les unités de détection et de mesure 30.

Une telle possibilité est permise par une décomposition de chacune des sous-unités en fonction logique programmable dans un tel circuit logique programmable.

Ainsi selon une telle décomposition fonctionnelle et comme le montre la figure 2, la sous-unité de détection 310 peut comprendre :

- un premier comparateur 311 adapté pour comparer l'amplitude du signal numérique représentatif 501 avec le premier seuil de déclenchement S1, le premier comparateur 311 présentant l'état 0, en tant que un premier état E1, lorsque l'amplitude du signal représentatif numérique est inférieure, voire est inférieure ou égale, au premier seuil de déclenchement S1 et un état 1, en tant que deuxième état E2, dans le cas contraire,
- un deuxième comparateur 312 adapté pour comparer l'amplitude du signal numérique représentatif 501 avec le deuxième seuil d'arrêt S2, le deuxième comparateur 312 présentant un état 0, en tant que troisième état E3, lorsque l'amplitude du signal représentatif numérique est supérieure, voire est supérieure ou égale, au deuxième seuil d'arrêt S2 et un état 1, en tant que quatrième état E4, dans le cas contraire,
- une première bascule 314 présentant une première entrée de bascule connectée au premier comparateur 311 et une deuxième entrée de bascule connectée au deuxième comparateur 312, la première bascule 314 étant configurée pour passer d'un état 0, en tant que cinquième état E5, à un état 1, en tant que sixième état E6, lorsque le premier comparateur présente un état 1 (c'est-à-dire le deuxième état E2), et pour passer de l'état 1 vers l'état 0 lorsque le deuxième comparateur 312 présente l'état 1 (c'est-à-dire le quatrième état E4),
- un compteur d'impulsions 316 connecté à une sortie de la première bascule 314 et configuré pour compter une impulsion à chaque fois que la première bascule 314 passe d'un état choisi parmi l'état 1, c'est-à-dire le sixième état E6, et l'état 0, c'est-à-dire le cinquième état E5, vers l'autre état parmi l'état 1 (E6) et l'état 0 (E5).

On notera que le compteur d'impulsions 316 présente, comme illustré sur la figure 2, une entrée remise à 0 connectée à l'unité d'analyse de telle manière que lorsque l'unité d'analyse transmet un signal de remise à zéro, le compteur d'impulsions 316 transmet le nombre d'impulsions électromagnétiques compté depuis la dernière remise à zéro à la sous-unité d'interface 340 et le nombre d'impulsions électromagnétiques est remis à zéro.

La sous-unité d'interface 340 est alors configurée pour fournir le nombre d'impulsions détecté à l'unité d'analyse 40.

Ainsi, avec de simples fonctions logiques accessibles avec un circuit logique programmable, il est possible d'obtenir une détection fiable contrairement au procédé mis en oeuvre dans le cadre de l'art antérieur. Une telle fiabilité est montrée sur les figures 3A et 3B, la figure 3A illustrant les risques de détection du type « faux positif » inhérent à l'utilisation d'un seul seuil S'1, la figure 3B illustrant les bénéfices de l'utilisation de deux seuils S1, S2.

On peut en effet constater, sur la figure 3A, qu'une impulsion électromagnétique peut présenter une variation d'amplitude erratique qui peut engendrer la détection de plusieurs impulsions (ici trois impulsions montrées sur la courbe 510') alors qu'une seule impulsion ne devrait en réalité être détectée comme le montre la courbe 510. Dans le cas de l'invention, l'utilisation d'un premier seuil de détection S1 et d'un deuxième seuil d'arrêt S2 avec le deuxième seuil d'arrêt S2 qui correspond une amplitude inférieure à celle du premier seuil de détection S1 permet d'éviter un tel problème. En effet, le premier seuil de détection relativement élevé permet d'attendre que l'impulsion atteigne une amplitude suffisamment importante, alors que le deuxième seuil d'arrêt permet de s'assurer que l'impulsion est bien terminée avant de la détecter.

Dans le cadre du comptage du nombre d'impulsion, de manière à autoriser une bonne autonomie au système de détection 1, le compteur d'impulsions 316 est un compteur 24bits, c'est-à-dire adapté pour compter un nombre d'impulsions électromagnétiques pouvant aller jusqu'à un peu plus de 16,7 millions d'impulsions électromagnétiques.

D'une même manière, il est possible de fournir la sous-unité de mesure de durée temporelle d'impulsion/s 320 selon une telle décomposition fonctionnelle. Selon une telle possibilité, la sous-unité de mesure de durée temporelle d'impulsion/s 320 comprend :

- une première horloge 321 configurée pour présenter par alternance un état 1, en tant que septième état et un état 0, en tant que huitième état E8, ceci avec une première fréquence d'alternance prédéfinie,
- une première porte logique 323, présentant une première entrée de porte reliée à une sortie de la première bascule 314 et une deuxième entrée de porte reliée à la première horloge 321, la première porte logique étant une porte du type ET et étant ainsi configurée pour présenter un état 1, en tant que neuvième état E9, lorsque la première bascule présente l'état 1 et lorsque la première horloge 321 présente l'état 1, la première porte logique 323 présentant un état 0, en tant que dixième état E10, le reste du temps,

- un compteur de durée d'impulsion/s 325 connecté à une sortie de la première porte logique 323 et configuré pour compter une pulsation de première horloge à chaque fois que la porte logique 323 présente l'état 1, c'est-à-dire le neuvième état E9, le nombre d'alternances comptées correspondant à la durée d'impulsion/s.

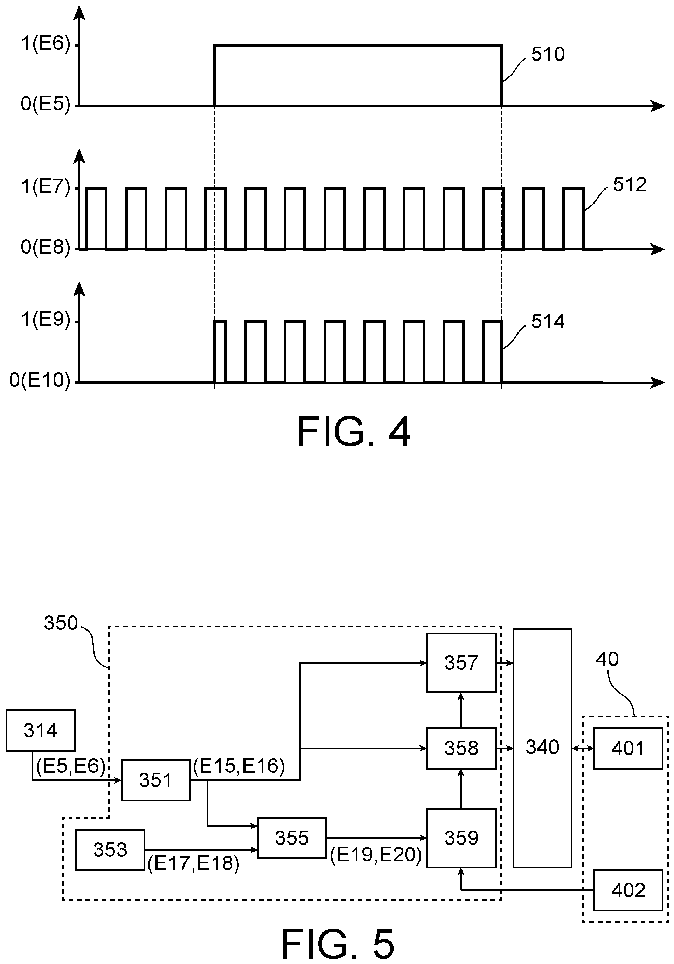

Le principe de comptage mise en oeuvre par la sous-unité de mesure de durée temporelle d'impulsion/s 320 est illustré par la figure 4. Le premier graphique illustre par la courbe 510 le signal de sortie la première bascule, le passage à 1 correspondant à la détection d'une impulsion électromagnétique et l'état 0 correspondant à l'absence d'impulsion électromagnétique. Le deuxième graphique illustre la sortie 512 de la première horloge 321 qui passe par alternance de l'état 1 à l'état 0 avec une fréquence donnée, une alternance correspondant à un battement de la première horloge 21. La première porte logique 323 permet de les combiner afin de fournir les battements d'horloge correspondants à la détection des impulsions électromagnétiques comme le montre le troisième graphique avec la courbe 514. De cette manière, le compteur de durée d'impulsion/s 325 va pouvoir compter le nombre de battements d'horloge correspondant à la détection d'impulsions électromagnétiques. Ce nombre de battements multiplié par la période de la première horloge $t_{clk}$ permet de remonter directement à la durée des impulsions électromagnétiques entre deux interrogations.

En effet, le compteur de durée d'impulsion/s 325 est, comme le compteur d'impulsions 316, muni d'une entrée remise à 0 connectée à l'unité d'analyse 40 de telle manière que lorsque l'unité d'analyse transmet un signal de remise à zéro, le compteur de durée d'impulsion/s 316 transmet le nombre de battements de la première horloge 321 compté depuis la dernière remise à zéro à la sous-unité d'interface 340 et remet à zéro le nombre de battements de la première horloge 321 compté.

La sous-unité d'interface 340 est alors configurée pour fournir le nombre de battements de la première horloge 321 compté à l'unité d'analyse 40 qui peut elle-même déterminée à partir de cette valeur et du nombre d'impulsions fourni par la sous-unité de détection 310, une durée d'impulsion moyenne. Une telle détermination peut être réalisée à partir de l'équation suivante :

$$\tau_{pulse} = \frac{N_{clk} \cdot t_{clk}}{N_{imp}}$$

Avec $N_{imp}$ le nombre d'impulsions électromagnétiques fourni par le compteur d'impulsions 316, $t_{clk}$ la période de l'horloge ; $N_{clk}$ le nombre de battements d'horloge fourni par le compteur de durée d'impulsion/s 325 et $\tau_{pulse}$ la durée d'impulsion moyenne calculée.

On notera que la fréquence de la première horloge est choisie en fonction de la durée moyenne attendue pour les impulsions électromagnétiques et la résolution temporelle recherchée. Dans le présent cas, les inventeurs ont choisi une fréquence de 100 MHz, soit une résolution de 10 ns. Bien entendu, cette valeur est fournie qu'à titre d'exemple et d'autres fréquences sont parfaitement envisageable, telles qu'une fréquence comprise entre 1 MHz et 500 MHz, sans que l'on sorte du cadre de l'invention.

Afin d'assurer une certaine autonomie à l'unité de détection et de mesure, le compteur de durée d'impulsion/s 325 peut être un compteur 32bits, c'est-à-dire apte à mesurer plus de 4,29 milliards de pulsation d'horloges.

D'une manière identique, aux sous-unités de détection et sous-unité de mesure de durée temporelle d'impulsion/s 320, la sous-unité de mesure d'amplitude maximale d'impulsions 330 peut également être fournie selon une telle décomposition fonctionnelle. Selon cette possibilité, la sous-unité de mesure d'amplitude maximale d'impulsions 330 peut comprendre une pluralité d'ensembles de comparaison, non illustrés, comprenant chacun un troisièmes comparateur et bascule respective.

Le troisième comparateur de chaque ensemble de comparaison est adapté pour comparer l'amplitude du signal numérique représentatif avec un troisième seuil de déclenchement respectif qui est distinct des troisième seuils de déclenchement des autres troisièmes comparateur, ledit troisième comparateur présentant un état 0, en tant que onzième état, lorsque l'amplitude du signal représentatif numérique est inférieure, voire est inférieure ou égale, au troisième seuil de déclenchement correspondant et un étant 1, en tant que douzième état, dans le cas contraire.

La troisième bascule de chaque ensemble de comparaison présentant une troisième entrée de bascule connectée au troisième comparateur dudit ensemble de comparaison, ladite troisième bascule étant configurée pour passer d'un état 0, en tant que treizième état, à un état 1, en tant que quatorzième état, lorsque le troisième comparateur dudit ensemble de comparaison présente l'état 1, c'est-à-dire le douzième état.

Les troisièmes seuils sont préférentiellement choisis pour être répartis sur une plage d'amplitudes attendues pour le signal numérique représentatif.

Ainsi, entre deux interrogations, dès que l'amplitude du signal numérique représentatif dépasse l'un des troisièmes seuils, la troisième bascule correspondante va passer de l'état 0, c'est-à-dire le treizième état, à l'état 1, c'est-à-dire le quatorzième état, et le fait que le signal numérique a présenté une amplitude supérieure audit troisième seuil de déclenchement sera enregistré par l'état de ladite troisième bascule. Lors de la mise à zéro, l'état de chacune des troisièmes bascules est transmis à la sous-unité d'interface 340 avant que les troisièmes bascules soient toutes passées à l'état 0, c'est-à-dire le treizième état. De cette manière, à partir de la correspondance entre les troisièmes bascules et les troisièmes seuils correspondants, l'unité d'analyse est à même de déterminer le troisième seuil de déclenchement supérieur qui a été dépassé par les impulsions électromagnétiques et estimer l'amplitude maximale des impulsions électromagnétiques qui ont été reçues entre deux mises à zéro.

Avec une telle unité de détection et de mesure 30, il est ainsi possible avec de simples fonctions logiques d'obtenir une bonne détection des impulsions électromagnétiques en temps réel et une information sur ces dernières dont la durée moyenne et l'amplitude maximale.

Une telle unité de détection et de mesure 30 est adapté pour permettre la mise en oeuvre d'un procédé de détection et de mesure d'impulsions comprenant les étapes suivantes :

- réception d'un signal numérique représentatif de l'enveloppe d'un signal électromagnétique reçu dans une bande de fréquences donnée dans laquelle est susceptible d'apparaître une perturbation électromagnétique, telle que celui fourni par l'unité de traitement et de numérisation 20,
- comparaison de l'amplitude du signal numérique représentatif avec le premier seuil de déclenchement S1 et le deuxième seuil d'arrêt S2, le deuxième seuil d'arrêt S2 correspondant à une amplitude inférieure à celle correspondant au premier seuil de déclenchement S2,
- détection d'une impulsion électromagnétique à chaque détection du passage de l'amplitude du signal numérique représentatif par le deuxième seuil S2 en front descendant après que l'amplitude du signal numérique représentatif soit passée par le premier seuil S1 en front montant.

De la même façon, afin de déterminer la durée des impulsions électromagnétique, l'unité de détection et de mesure 30 est ainsi adaptée pour la mise en oeuvre d'un procédé pour déterminé la durée des impulsions électromagnétiques comprenant les étapes suivantes :

- fourniture d'un premier signal d'horloge présentant une première fréquence d'alternance prédéfinie,
- modulation du premier signal d'horloge avec un signal de détection d'impulsions électromagnétiques fourni lors de l'étape de détection d'une impulsion électromagnétique,
- comptage du nombre de signal d'horloge restant après modulation avec le signal de détection d'impulsions électromagnétiques.

On peut noter également que l'unité de détection et de mesure 30 est également adaptée pour permettre la mesure de l'amplitude maximale des impulsions électromagnétiques ceci par la mise en oeuvre d'un procédé comprenant les étapes suivantes :

- comparaison de l'amplitude du signal numérique représentatif avec une pluralité de troisièmes seuils de déclenchement distincts les uns des autres afin de détecter si l'amplitude du signal numérique atteint et/ou dépasse lesdits troisième seuils de déclenchement, les troisièmes seuils de déclenchement étant réparties sur une plage d'amplitudes attendues pour le signal numérique représentatif,
- le troisième seuil de déclenchement correspondant à l'amplitude du signal numérique la plus haute qui a été atteint/ dépassé par le signal représentatif, ledit troisième seuil de déclenchement correspondant à la mesure d'amplitude maximale.

Dans le cadre d'un deuxième mode de réalisation de l'unité de détection et de mesure 30 peut, comme cela est montré sur la figure 5, en outre comporter une sous-unité de mesure d'une fréquence de répétition des impulsions électromagnétiques 350.

Ainsi, une unité de détection et de mesure 30 selon le deuxième mode de réalisation se différencie d'une unité de détection et de mesure 30 selon le premier mode de réalisation uniquement en ce qu'elle comprend en outre la sous-unité de mesure d'une période de répétition des impulsions électromagnétiques 350.

Selon la possibilité avantageuse de l'invention dans laquelle l'unité de détection et de mesure 30 peut comprendre un circuit logique programmable, il est également possible dans le cadre de ce deuxième mode de réalisation de fournis une décomposition fonctionnelle de la sous-unité de mesure d'une période de répétition des impulsions électromagnétiques 350. Selon cette possibilité, la sous-unité de mesure d'une période de répétition des impulsions électromagnétiques 350 peut comprendre, comme illustré sur la figure 5 :

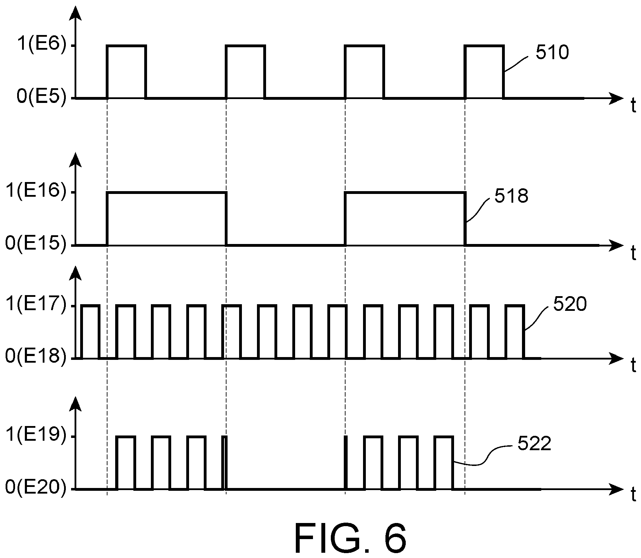

- un diviseur de fréquence 351 configuré pour basculer entre un état 0, en tant que quinzième état E15 et un état 1, en tant que seizième E16 état, à chaque passage de la première bascule 314 à un état donné choisi parmi l'état 0, c'est-à-dire e cinquième état E5, et l'état 1, c'est-à-dire le sixième état E6 (ici, comme cela sera montré en lien avec la figure 6, le passage à l'état 1 (E6)),
- un compteur de nombre de double périodes 357 connecté à une sortie de du diviseur de fréquence 351 et configuré pour compter une période à chaque fois que le diviseur de fréquence 351 passe d'un état choisi parmi l'état 0, c'est-à-dire le quinzième état E15, et l'état 1, c'est-à-dire le seizième état E16, à l'autre état parmi l'état 1 (E16) et l'état 0 (E15), ici à chaque passage en front montant de l'état 0 (E15) à l'état 1 (E16),
- une deuxième horloge 353 configurée pour présenter par alternance un état 1, en tant que dix-septième état E17, et un état 0 en tant que dix-huitième état E18 ceci avec une deuxième fréquence d'alternance prédéfinie,

- une deuxième porte logique 355 présentant une troisième entrée de porte reliée à une sortie du diviseur de fréquence 351 et une quatrième entrée de porte reliée à la deuxième horloge 353, la deuxième porte logique 355 étant configurée pour présenter un état 1, en tant que dix-neuvième état E19, lorsque le diviseur de fréquence 351 présente l'état 1, c'est-à-dire le quinzième état E15, et lorsque la deuxième horloge 353 présente l'état 1, c'est-à-dire le dix-septième état E17, la porte logique présentant un état 0, en tant que vingtième état E20, le reste du temps,

- un compteur de durée de périodes 359 connecté à une sortie deuxième porte logique 355 et configuré pour compter une pulsation de deuxième horloge à chaque fois que le diviseur de fréquence 351 passe d'un état choisi parmi l'état 0, c'est à dure le quinzième état E15, et l'état 1, c'est-à-dire le seizième état E16, à l'autre état parmi l'état 0 (E15) et l'état 1 (E16).

On notera que, en conformité à ce deuxième mode de réalisation et comme illustré sur la figure 5, la sous-unité de mesure d'une période de répétition des impulsions électromagnétiques 350 comprend en outre une mémoire tampon 358, connectée à une sortie du diviseur de fréquence 351 et du compteur de durée de périodes 359, et qui est configurée pour faire interface entre ces dernier et la sous-unité d'interface 340. La mémoire tampon 358 est plus précisément configurée pour récupérer la valeur du compteur de durée de périodes 359 à chaque passage de la sortie du diviseur de fréquence 351 à l'état 0, c'est-à-dire au quinzième état E15, assurant, de fait, que seules les périodes complètes du diviseur de fréquence 351 soit prise en compte.

Conformément à cette utilisation d'une mémoire tampon 358, le compteur de nombre de doubles périodes 357 est configuré pour compter une période à chaque fois que le diviseur de fréquence 351 passe d'un état parmi l'état 1, c'est-à-dire le seizième état E16, à l'état 0, c'est-à-dire le dix-septième état E17, assurant ainsi que seules les alternances complètes soient comptabilisées.

Le principe de mesure de la période de répétition des impulsions électromagnétiques est illustré par la figure 6. Le premier graphique illustre un exemple de signal 510 fournie par la première bascule 314 pour des impulsions électromagnétiques régulières. Le deuxième graphique montre la sortie du diviseur de fréquence 351 lorsqu'il reçoit le signal 510, on notera que le signal 518 en sortie du diviseur de fréquence 351 correspond, comme il se doit, à deux périodes de celui des impulsions électromagnétiques. Ainsi, le signal 518 présente l'état 1 pour une période sur deux du signal en sortie de la première bascule 314. Le troisième graphique illustre la sortie 520 de la deuxième horloge 353 qui passe par alternance de l'état 1 à l'état 0 avec une deuxième fréquence donnée. La deuxième porte logique 355 permet de les combiner afin de fournir les battements d'horloge correspondant à une période sur deux du signal 510 correspondant aux impulsions électromagnétique comme le montre le quatrième graphique avec la courbe 522. De cette manière, le compteur de durée de périodes 359 va pouvoir compter le nombre de battements de la deuxième horloge correspondant à une période sur deux d. Ce nombre de battements multiplié par la période de deuxième l'horloge $t_{clk2}$ permet de remonter directement à la durée des impulsions électromagnétiques entre deux interrogations.

En effet, le compteur de durée de périodes 359 et la mémoire tampon 358 sont, comme le compteur d'impulsions 316, muni d'une entrée remise à 0 connectée à l'unité d'analyse 40, ici au travers du compteur de durée de période 359 pour la mémoire tampon, de telle manière que lorsque l'unité d'analyse 40 transmet un signal de remise à zéro, la mémoire tampon 358 transmet à la sous-unité d'interface 340 le nombre de battements de deuxième horloge 321 compté depuis la dernière remise à zéro pour les alternances complètes du diviseur de fréquence 351 et le nombre de battements de la deuxième horloge 355 de la mémoire tampon 358 et du compteur de durée de période 359 est remis à zéro.

D'une manière similaire, le compteur de nombre de double périodes 357 est également muni d'une entrée remise à 0 connectée à l'unité d'analyse 40 au travers, ici, du compteur de durée de période 359 et de la mémoire tampon, de telle manière que lorsque l'unité d'analyse 40 transmet un signal de remise à zéro, le compteur de nombre de double périodes 357 transmet le nombre de double périodes compté depuis la dernière remise à zéro, ces doubles périodes ne comportant, de manière préférentielle, que les doubles périodes complètes, et le nombre de double périodes compté du compteur de nombre de double périodes 357 est remis à zéro.

La sous-unité d'interface 340 est alors configurée pour fournir le nombre de battements $N_{clk2}$ de deuxième horloge 321 compté à l'unité d'analyse 40 qui peut elle-même déterminée à partir de cette valeur et du nombre de double période $N_{div}$ fourni par le compteur de nombre de double périodes 357, une fréquence moyenne des impulsions électromagnétique. Une telle détermination peut être réalisée à partir de l'équation suivante :

$$f_{imp} = \frac{N_{div}}{N_{clk2} \cdot t_{clk2}}$$

Avec $N_{div}$ le nombre de double période fourni par le compteur de nombre de double périodes 357, $t_{clk2}$ la période de la deuxième horloge ; $N_{clk2}$ le nombre de battements de la deuxième horloge 321 compté par le compteur de durée de périodes 359 et $f_{imp}$ la fréquence moyenne des impulsions électromagnétiques déterminée.

On notera que la fréquence de la deuxième horloge est choisie en fonction de la fréquence attendue pour les impulsions électromagnétiques et la résolution recherchée. Dans le présent cas, les inventeurs ont choisi une fréquence de 10 Mhz, ce qui correspond à une fréquence attendue inférieure à 10 MHz. Bien entendu, cette valeur est fournie qu'à titre d'exemple et d'autres fréquences sont parfaitement envisageable, telles qu'une fréquence comprise entre 10 kHz et 50 MHz, sans que l'on sorte du cadre de l'invention.

Afin d'assurer une certaine autonomie à l'unité de détection et de mesure 30, le compteur de nombre de double périodes 357 peut être un compteur 32bits, c'est-à-dire apte à compter plus de 4,29 milliards de double périodes et le compteur de durée de périodes 359 peut être un compteur 32bits, c'est-à-dire apte à mesurer plus de 4,29 milliards de pulsation de deuxième horloge.

On notera, que ce soit dans le cadre du premier mode de réalisation ou dans le deuxième mode de réalisation, les différents étages fonctionnels des différentes sous-unités présentent des états choisis arbitrairement comme étant à 1 ou à 0 de manière à faciliter la lecture du présent document. Bien entendu, une partie, ou la totalité de ces états, peut être inversé sans que l'on sorte du cadre de l'invention. De la même façon, avec de telles inversions d'état, par exemple, dans le cas où la sortie de la première bascule serait inversée, la première porte logique peut être alors être du type ou exclusif, c'est-à-dire apte à passer à l'état 1 lorsque la première bascule et la première horloge présente chacune l'état 0.

## Revendications

1. Unité de détection et de mesure (30) pour la détection de perturbation électromagnétique, l'unité de détection et de mesure (30) étant configurée pour recevoir un signal numérique représentatif (501) de l'enveloppe d'un signal électromagnétique reçu dans une bande de fréquences donnée dans laquelle est susceptible d'apparaître une perturbation électromagnétique,

   l'unité de détection et de mesure (30) comprenant :

   - un circuit logique programmable qui a été préalablement programmé pour faire office d'une sous-unité de détection (310) configurée pour comparer l'amplitude du signal numérique représentatif (501) avec un premier seuil de déclenchement (S1) et à un deuxième seuil d'arrêt (S2), le deuxième seuil d'arrêt (S2) correspondant à une amplitude inférieure à celle correspondant au premier seuil de déclenchement (S1), la sous-unité de détection (310) étant en outre configurée pour détecter une impulsion électromagnétique à chaque détection du passage de l'amplitude du signal numérique représentatif par le deuxième seuil d'arrêt (S2) en front descendant après que l'amplitude du signal numérique représentatif soit passée par le premier seuil de déclenchement (S1) en front montant.

2. Unité de détection et de mesure (30) selon la revendication 1, dans laquelle l'unité de détection et de mesure (30) comprend en outre une sous-unité de mesure de durée temporelle d'impulsion/s (320) en communication avec la sous-unité de détection (310), la sous-unité de mesure temporelle d'impulsion/s (320) étant configurée pour mesurer la durée d'impulsion/s entre les passages par l'amplitude du signal numérique représentatif (501) du premier seuil de déclenchement (S1) en front montant et le passage du deuxième seuil d'arrêt (S2) en front descendant.

3. Unité de détection et de mesure (30) selon la revendication 1 ou 2, dans laquelle la sous-unité de détection (310) comprend :

   - un premier comparateur (311) adapté pour comparer l'amplitude du signal numérique représentatif (501) avec le premier seuil de déclenchement (S1), le premier comparateur (311) présentant un premier état (E1) lorsque l'amplitude du signal représentatif numérique est inférieure, voire est inférieure ou égale, au premier seuil de déclenchement (S1) et un deuxième état (E2) dans le cas contraire,
   - un deuxième comparateur (312) adapté pour comparer l'amplitude du signal numérique représentatif (501) avec le deuxième seuil d'arrêt (S2), le deuxième comparateur (312) présentant un troisième état (E3) lorsque l'amplitude du signal représentatif numérique est supérieure, voire est supérieure ou égale, au deuxième seuil d'arrêt (S2) et un quatrième état (E4) dans le cas contraire,
   - une première bascule (314) présentant une première entrée de bascule connectée au premier comparateur (311) et une deuxième entrée de bascule connectée au deuxième comparateur (312), la première bascule (314) étant configurée pour passer d'un cinquième état (E5) à un sixième état (E6) lorsque le premier comparateur présente le deuxième état (E2), et pour passer du sixième état (E6) vers le cinquième état (E5) lorsque le deuxième comparateur (312) présente le quatrième état (E4),
   - un compteur d'impulsions (316) connecté à une sortie de la première bascule (314) et configuré pour compter une impulsion à chaque fois que la première bascule (314) passe d'un état choisi parmi le sixième état (E6) et le cinquième état (E5) vers l'autre état parmi le sixième état (E6) et le cinquième état (E5).

4. Unité de détection et de mesure (30) selon les revendications 2 et 3, dans laquelle la sous-unité de mesure de durée temporelle d'impulsion/s (320) comprend :

- une première horloge (321) configurée pour présenter par alternance un septième état (E7) et un huitième état (E8) ceci avec une première fréquence d'alternance prédéfinie,
- une première porte logique (323) présentant une première entrée de porte reliée à une sortie de la première bascule (314) et une deuxième entrée de porte reliée à la première horloge (321), la première porte logique étant configurée pour présenter un neuvième état (E9) lorsque la première bascule (314) présente le sixième état (E6) et lorsque l'horloge (321) présente le septième état (E7), la première porte logique (323) présentant un dixième état (E10) le reste du temps,
- un compteur de durée d'impulsion/s connecté à une sortie de la première porte logique (323) et configuré pour compter une pulsation de première horloge à chaque fois que la première porte logique (323) présente le neuvième état (E9), le nombre d'alternances comptées correspondant à la durée d'impulsion/s.

5. Unité de détection et de mesure (30) selon l'une quelconque des revendications 1 à 4 comprenant en outre une sous-unité de mesure d'amplitude maximale d'impulsions (330) apte à mesurer un niveau amplitude maximale atteinte par le signal numérique représentatif (501).

6. Unité de détection et de mesure (30) selon la revendication 5, dans laquelle la sous-unité de mesure d'amplitude maximale d'impulsions (330) comprend une pluralité d'ensembles de comparaison comprenant chacun un troisièmes comparateur et bascule respective,

le troisième comparateur de chaque ensemble de comparaison étant adapté pour comparer l'amplitude du signal numérique représentatif avec un troisième seuil de déclenchement respectif qui est distinct des troisième seuils de déclenchement des autres troisièmes comparateur, ledit troisième comparateur présentant un onzième état lorsque l'amplitude du signal représentatif numérique est inférieure, voire est inférieure ou égale, au troisième seuil de déclenchement correspondant et un douzième état dans le cas contraire,
la troisième bascule de chaque ensemble de comparaison présentant une troisième entrée de bascule connectée au troisième comparateur dudit ensemble de comparaison, ladite troisième bascule étant configurée pour passer d'un treizième état à un quatorzième état lorsque le troisième comparateur dudit ensemble de comparaison présente le douzième état,
les ensembles de comparaison étant configurés pour que les troisièmes seuils de déclenchement des troisièmes comparateurs soient répartis sur une plage d'amplitudes attendues pour le signal numérique représentatif.

7. Unité de détection et de mesure (30) selon l'une quelconque des revendications 1 à 6 comprenant une sous-unité de mesure d'une période de répétition des impulsions électromagnétiques (350).

8. Unité de détection et de mesure (30) selon les revendications 3 et 7 prises seules ou en combinaison avec l'une quelconque des revendications 4 à 5, dans laquelle la sous-unité de mesure de fréquence de répétition des impulsions électromagnétique (350) comprend :

- un diviseur de fréquence (351) configuré pour basculer entre un quinzième état (E15) et seizième état (E16) à chaque passage de la première bascule (314) à un état donné choisi parmi le cinquième état (E5) et le sixième état (E6),
- un compteur de nombre de double périodes (357) connecté à une sortie du diviseur de fréquence (351) et configuré pour compter une double période à chaque fois que le diviseur de fréquence (351) passe d'un état (0,1) choisi parmi le quinzième état (E15) et le seizième état (E16) à l'autre état (1,0) parmi le quinzième état (E15) et le seizième état (E16),
- une deuxième horloge (353) configurée pour présenter par alternance un dix-septième état (E17) et un dix-huitième état (E18) ceci avec une deuxième fréquence d'alternance prédéfinie,
- une deuxième porte logique (355) présentant une troisième entrée de porte reliée à une sortie du diviseur de fréquence (351) et une quatrième entrée de porte reliée à la deuxième horloge (353), la deuxième porte logique (355) étant configurée pour présenter un dix-neuvième état (E19) lorsque le diviseur de fréquence (351) présente le quinzième état (E15) et lorsque la deuxième horloge (353) présente le dix-septième état E(17), la porte logique présentant un vingtième état (E20) le reste du temps,
- un compteur de durée de périodes connecté à une sortie de la deuxième porte logique (355) et configuré pour compter une pulsation de deuxième horloge à chaque fois que le diviseur de fréquence (351) passe d'un état (0,1) choisi parmi le quinzième état (E15) et le seizième état (E16) à l'autre état (1,0) parmi le quinzième état (E15) et le seizième état (E16).

**9.** Unité de détection et de mesure selon la revendication 8, comprenant une mémoire tampon (358) configuré pour récupérer la valeur du compteur de durée de périodes à chaque passage du diviseur de fréquence (351) du seizième état (E16) vers le quinzième état (E15).

**10.** Unité de détection et de mesure (30) selon l'une quelconque des revendications 1 à 9, dans laquelle la sous-unité de détection (310) est configurée pour recevoir un signal de mise à zéro et pour réaliser, lors de la réception de ce signal de mise à zéro, une fourniture d'un nombre d'impulsions électromagnétiques détectées depuis une précédente mise à zéro et une réinitialisation à zéro d'un comptage du nombre d'impulsions électromagnétiques.

**11.** Unité de détection et de mesure (30) selon les revendications 2, 5 et 7 prises en combinaisons, dans laquelle la sous-unité de détection (310), la sous-unité de mesure de durée temporelle d'impulsion/s (320), la sous-unité de mesure d'amplitude maximale d'impulsions (330) et la sous-unité de mesure d'une période de répétition des impulsions électromagnétiques (350) sont configurées pour recevoir un signal de mise à zéro et pour réaliser, lors de la réception de ce signal de mise à zéro :

- une fourniture de respectivement un nombre d'impulsions électromagnétiques détectées, une durée temporelle d'impulsion/s, une amplitude maximale d'impulsions mesurée, et une période de répétition des impulsions électromagnétiques mesurée depuis une précédente mise à zéro et
- une réinitialisation à zéro d'un comptage du nombre d'impulsions électromagnétiques.

**12.** Système de détection (1) de perturbation électromagnétique comprenant :

- une unité de réception de signaux électromagnétique configurée pour recevoir au moins une partie du rayonnement électromagnétique auquel est soumis le système de détection sous la forme d'un signal électromagnétique reçu dans une bande de fréquences donnée et pour fournir un signal numérique représentatif de l'enveloppe dudit signal électromagnétique,
- une unité de détection et de mesure selon l'une quelconque des revendications 1 à 11.

**13.** Procédé d'analyse pour la détection de perturbation électromagnétique mis en oeuvre à l'aide d'une unité de détection et de mesure selon l'une quelconque des revendications 1 à 11, le procédé comprenant les étapes de :

- réception d'un signal numérique représentatif de l'enveloppe d'un signal électromagnétique reçu dans une bande de fréquences donnée dans laquelle est susceptible d'apparaître une perturbation électromagnétique,
- comparaison de l'amplitude du signal numérique représentatif avec un premier seuil de déclenchement et un deuxième seuil d'arrêt, le deuxième seuil d'arrêt correspondant à une amplitude inférieure à celle correspondant au premier seuil de déclenchement,
- détection d'une impulsion électromagnétique à chaque détection du passage de l'amplitude du signal numérique représentatif par le deuxième seuil en front descendant après que l'amplitude du signal numérique représentatif soit passée par le premier seuil en front montant.

**14.** Procédé d'analyse pour la détection de perturbation électromagnétique selon la revendication 13, comprenant en outre les étapes de :

- fourniture d'un premier signal d'horloge présentant une première fréquence d'alternance prédéfinie,
- modulation du premier signal d'horloge avec un signal de détection d'impulsions électromagnétiques fourni lors de l'étape de détection d'une impulsion électromagnétique,
- comptage du nombre de signal d'horloge restant après modulation avec le signal de détection d'impulsions électromagnétiques.

**Patentansprüche**

**1.** Erfassungs- und Messeinheit (30) zum Erfassen elektromagnetischer Störungen, wobei die Erfassungs- und Messeinheit (30) konfiguriert ist, um ein digitales Signal zu empfangen, das repräsentativ (501) ist für die Hülle eines elektromagnetischen Signals, das in einem bestimmten Frequenzband empfangenen wurde, in dem eine elektromagnetische Störung auftreten kann,

wobei die Erfassungs- und Messeinheit (30) umfasst:

- eine programmierbare Logikschaltung, die zuvor programmiert wurde, um als eine Erfassungsuntereinheit (310) zu fungieren, die konfiguriert ist, um die Amplitude des repräsentativen digitalen Signals (501) mit einer ersten Auslöseschwelle (S1) und einer zweiten Stoppschwelle (S2) zu vergleichen, wobei die zweite Stoppschwelle (S2) einer Amplitude entspricht, die kleiner ist als die, die der ersten Auslöseschwelle (S1) entspricht, wobei die Erfassungsuntereinheit (310) ferner konfiguriert ist, zum Erfassen eines elektromagnetischen Impulses bei jeder Erfassung des Durchgangs der Amplitude des repräsentativen digitalen Signals über die zweite Stoppschwelle (S2), an der abfallenden Flanke, nachdem die Amplitude des repräsentativen digitalen Signals über die erste Auslöseschwelle (S1) gegangen ist, an der ansteigenden Flanke.

2. Erfassungs- und Messeinheit (30) nach Anspruch 1, wobei die Erfassungs- und Messeinheit (30) ferner eine Untereinheit zur Messung der Dauer der Impulszeit(en) (320) umfasst, die in Kommunikation mit der Erfassungsuntereinheit (310) steht, wobei die Untereinheit zur zeitlichen Messung des Impulses (der Impulse) (320) konfiguriert ist, um die Dauer des Impulses (der Impulse) zwischen den Durchgängen durch die Amplitude des repräsentativen digitalen Signals (501) der ersten Auslöseschwelle (S1) zu messen, an der ansteigenden Flanke, und dem Durchgang der zweiten Stoppschwelle (S2), an der abfallenden Flanke.

3. Erfassungs- und Messeinheit (30) nach Anspruch 1 oder 2, wobei die Erfassungsuntereinheit (310) umfasst:

   - einen ersten Komparator (311), der angepasst ist, um die Amplitude des repräsentativen digitalen Signals (501) mit der ersten Auslöseschwelle (S1) zu vergleichen, wobei der erste Komparator (311) einen ersten Zustand (E1) aufweist, wenn die Amplitude des repräsentativen digitalen Signals kleiner oder kleiner oder gleich der ersten Auslöseschwelle (S1) ist, und einen zweiten Zustand (E2) im gegengesetzten Fall,
   - einen zweiten Komparator (312), der angepasst ist, um die Amplitude des repräsentativen digitalen Signals (501) mit der zweiten Stoppschwelle (S2) zu vergleichen, wobei der zweite Komparator (312) einen dritten Zustand (E3) aufweist, wenn die Amplitude des repräsentativen digitalen Signals größer oder größer oder gleich der zweiten Stoppschwelle (S2) ist, und einen vierten Zustand (E4) im gegengesetzten Fall,
   - ein erstes Flipflop (314), das einen ersten Flipflop-Eingang aufweist, der mit dem ersten Komparator (311) verbunden ist, und einen zweiten Flipflop-Eingang, der mit dem zweiten Komparator (312) verbunden ist, wobei das erste Flipflop (314) konfiguriert ist, um von einem fünften Zustand (E5) in einen sechsten Zustand (E6) überzugehen, wenn der erste Komparator den zweiten Zustand (E2) aufweist, und vom sechsten Zustand (E6) in den fünften Zustand (E5) überzugehen, wenn der zweite Komparator (312) den vierten Zustand (E4) aufweist,
   - einen Impulszähler (316), der mit einem Ausgang des ersten Flipflops (314) verbunden ist und konfiguriert ist, um jedes Mal einen Impuls zu zählen, wenn der erste Flipflop (314) von einem Zustand, der von einem vom sechsten Zustand (E6) und dem fünften Zustand (E5) gewählt wurde, in den anderen Zustand aus dem sechsten Zustand (E6) und dem fünften Zustand (E5) übergeht.

4. Erfassungs- und Messeinheit (30) nach Anspruch 2 und 3, wobei die Untereinheit zur Messung der Dauer der Impulszeit(en) (320) umfasst:

   - eine erste Uhr (321), die konfiguriert ist, um abwechselnd einen siebten Zustand (E7) aufzuweisen und einen achten Zustand (E8), der eine vordefinierte erste Wechselfrequenz hat,
   - ein erstes Logikgatter (323), das einen ersten Gattereingang aufweist, der an einen Ausgang des ersten Flipflops (314) angeschlossen ist, und einem zweiten Gattereingang, der an die erste Uhr (321) angeschlossen ist, wobei das erste Logikgatter konfiguriert ist, um einen neunten Zustand (E9) aufzuweisen, wenn das erste Flipflop (314) den sechsten Zustand (E6) aufweist und wenn die Uhr (321) den siebten Zustand (E7) aufweist, wobei das erste Logikgatter (323) für die restliche Zeit einen zehnten Zustand (E10) aufweist,
   - einen Zähler für die Dauer des Impulses (der Impulse), der mit einem Ausgang des ersten Logikgatters (323) verbunden ist und konfiguriert ist, um eine Pulsation der ersten Uhr zu zählen, jedes Mal, wenn das erste Logikgatter (323) den neunten Zustand (E9) aufweist, wobei die Anzahl der gezählten Wechsel der Dauer des Impulses (der Impulse) entspricht.

5. Erfassungs- und Messeinheit (30) nach einem der Ansprüche 1 bis 4, ferner eine Untereinheit zur Messung der maximalen Impulsamplitude (330) umfassend, die zum Messen eines maximalen Amplitudenniveaus geeignet ist, das vom repräsentativen digitalen Signal (501) erreicht wird.

6. Erfassungs- und Messeinheit (30) nach Anspruch 5, wobei die Untereinheit zur Messung der maximalen Impulsamplitude (330) eine Vielzahl von Vergleichssätzen umfasst, die jeweils einen dritten Komparator und ein jeweiliges Flipflop umfassen,

   wobei der dritte Komparator jedes Vergleichssatzes angepasst ist, um die Amplitude des repräsentativen digitalen Signals mit einer jeweiligen dritten Auslöseschwelle zu vergleichen, die sich von den dritten Auslöseschwellen der anderen dritten Komparatoren unterscheidet, wobei der dritte Komparator einen elften Zustand aufweist, wenn die Amplitude des repräsentativen digitalen Signals kleiner oder kleiner oder gleich der entsprechenden dritten Auslöseschwelle ist, und einen zwölften Zustand im gegengesetzten Fall,

wobei das dritte Flipflop jedes Vergleichssatzes einen dritten Flipflop-Eingang aufweist, der mit dem dritten Komparator des Vergleichssatzes verbunden ist, wobei das dritte Flipflop konfiguriert ist, um von einem dreizehnten Zustand in einen vierzehnten Zustand überzugehen, wenn der dritte Komparator des Vergleichssatzes den zwölften Zustand aufweist,

wobei die Vergleichssätze so konfiguriert sind, dass die dritten Auslöseschwellen der dritten Komparatoren über einen Bereich von Amplituden verteilt werden, die für das repräsentative digitale Signal erwartet werden.

7. Erfassungs- und Messeinheit (30) nach einem der Ansprüche 1 bis 6, eine Untereinheit zur Messung einer Periode der Wiederholung elektromagnetischer Impulse (350) umfassend.

8. Erfassungs- und Messeinheit (30) nach den Ansprüchen 3 und 7 allein betrachtet oder in Kombination mit einem der Ansprüche 4 bis 5, wobei die Untereinheit zur Messung der Frequenz der Wiederholung elektromagnetischer Impulse (350) umfasst:

- einen Frequenzteiler (351), der konfiguriert ist, um zwischen einem fünfzehnten Zustand (E15) und einem sechzehnten Zustand (E16) umzuschalten bei jedem Durchgang des ersten Flipflops (314) in einen bestimmten Zustand, der aus dem fünften Zustand (E5) und dem sechsten Zustand (E6) ausgewählt ist,

- einen Zähler der Anzahl der doppelten Perioden (357), der mit einem Ausgang des Frequenzteilers (351) verbunden ist und konfiguriert ist, um eine doppelte Periode zu zählen, jedes Mal, wenn der Frequenzteiler (351) von einem Zustand (0,1), der aus dem fünfzehnten Zustand (E15) und dem sechzehnten Zustand (E16) ausgewählt ist, in den anderen Zustand (1,0) übergeht, aus dem fünfzehnten Zustand (E15) und dem sechzehnten Zustand (E16),

- eine zweite Uhr (353), die konfiguriert ist, um abwechselnd einen siebzehnten Zustand (E17) aufzuweisen und einen achtzehnten Zustand (E18), der eine vordefinierte zweite Wechselfrequenz hat,

- ein zweites Logikgatter (355), das einen dritten Gattereingang aufweist, der an einen Ausgang des Frequenzteilers (351) angeschlossen ist, und einen vierten Gattereingang, der an die zweite Uhr (353) angeschlossen ist, wobei das zweite Logikgatter (355) konfiguriert ist, um einen neunzehnten Zustand (E19) aufzuweisen, wenn der Frequenzteiler (351) den fünfzehnten Zustand (E15) aufweist und wenn die zweite Uhr (353) den siebzehnten Zustand E(17) aufweist, wobei das Logikgatter für die restliche Zeit einen zwanzigsten Zustand (E20) aufweist,

- einen Zähler der Periodendauer, der mit einem Ausgang des zweiten Logikgatters (355) verbunden ist und konfiguriert ist, um eine Pulsation der zweiten Uhr zu zählen, jedes Mal, wenn der Frequenzteiler (351) von einem Zustand (0,1), der aus dem fünfzehnten Zustand (E15) und dem sechzehnten Zustand (E16) ausgewählt ist, in den anderen Zustand (1,0) übergeht, aus dem fünfzehnten Zustand (E15) und dem sechzehnten Zustand (E16).

9. Erfassungs- und Messeinheit (30) nach Anspruch 8, einen Pufferspeicher (358) umfassend, der konfiguriert ist, um den Wert des Zählers der Periodendauer bei jedem Durchgang des Frequenzteilers (351) vom sechzehnten Zustand (E16) zum fünfzehnten Zustand (E15) abzurufen.

10. Erfassungs- und Messeinheit (30) nach einem der Ansprüche 1 bis 9, wobei die Erfassungsuntereinheit (310) konfiguriert ist, um ein Nullungssignal zu empfangen und, beim Empfang dieses Nullungssignals, eine Bereitstellung einer Anzahl von elektromagnetischen Impulsen zu bewirken, die seit einer vorherigen Nullung erfasst wurden, und eine Rückstellung auf Null einer Zählung der Anzahl von elektromagnetischen Impulsen.

11. Erfassungs- und Messeinheit (30) nach den Ansprüchen 2, 5 und 7 in Kombination betrachtet, wobei die Erfassungsuntereinheit (310), die Untereinheit zur Messung der Dauer der Impulszeit(en) (320), die Untereinheit zur Messung der maximalen Impulsamplitude (330) und die Untereinheit zur Messung einer Periode der Wiederholung elektromagnetischer Impulse (350) konfiguriert sind, um ein Nullungssignal zu empfangen und um zu bewirken, beim Empfang dieses Nullungssignals:

- eine Bereitstellung von jeweils einer Anzahl erfasster elektromagnetischer Impulse, einer Dauer der Impulszeit(en), einer maximalen Amplitude der gemessenen Impulse und einer Periode der Wiederholung elektromagnetischer Impulse, die seit einer vorherigen Nullung gemessen wurde, und

- eine Rückstellung auf Null einer Zählung der Anzahl elektromagnetischer Impulse.

12. Erfassungssystem (1) für elektromagnetische Störungen, umfassend:

- eine Empfangseinheit von elektromagnetischen Signalen, die konfiguriert ist, um mindestens einen Teil der elektromagnetischen Strahlung zu empfangen, der das Erfassungssystem in Form eines elektromagnetischen Signals ausgesetzt ist, das in einem bestimmten Frequenzband empfangen wird, und ein digitales Signal bereitzustellen, das für die Hülle des elektromagnetischen Signals repräsentativ ist,
- eine Erfassungs- und Messeinheit nach einem der Ansprüche 1 bis 11.

13. Analyseverfahren zur Erfassung elektromagnetischer Störungen, das unter Verwendung einer Erfassungs- und Messeinheit nach einem der Ansprüche 1 bis 11 implementiert wird, wobei das Verfahren die Schritte umfasst:

- Empfang eines digitalen Signals, das repräsentativ ist für die Hülle eines elektromagnetischen Signals, das in einem bestimmten Frequenzband empfangenen wurde, in dem eine elektromagnetische Störung auftreten kann,
- Vergleich der Amplitude des repräsentativen digitalen Signals mit einer ersten Auslöseschwelle und einer zweiten Stoppschwelle, wobei die zweite Stoppschwelle einer Amplitude entspricht, die kleiner ist als die, die der ersten Auslöseschwelle entspricht,
- Erfassung eines elektromagnetischen Impulses bei jeder Erfassung des Durchgangs der Amplitude des repräsentativen digitalen Signals über die zweite Schwelle, an der abfallenden Flanke, nachdem die Amplitude des repräsentativen digitalen Signals über die erste Schwelle gegangen ist, an der ansteigenden Flanke.

14. Analyseverfahren zur Erfassung elektromagnetischer Störungen nach Anspruch 13, ferner die Schritte umfassend:

- Bereitstellung eines ersten Signals der Uhr, das eine vordefinierte erste Wechselfrequenz aufweist,
- Modulation des ersten Signals der Uhr mit einem Signal der Erfassung elektromagnetischer Impulse, das während dem Schritt der Erfassung eines elektromagnetischen Impulses bereitgestellt wird,
- Zählung der Anzahl der verbleibenden Signale der Uhr nach der Modulation mit dem Signal der Erfassung elektromagnetischer Impulse.

**Claims**

1. Detection and measurement unit (30) for detecting electromagnetic interference, the detection and measurement unit (30) being configured to receive a digital signal representative (501) of the envelope of an electromagnetic wave received in a given frequency band, in which an electromagnetic interference is susceptible to appear,
the measurement and detection unit (30) comprising:

- a programmable logic circuit which was previously programmed to act as a detection subunit (310) configured to compare the amplitude of the representative digital signal (310) with a first triggering threshold (S1) and a second stopping threshold (S2), the second stopping threshold (S2) corresponding to an amplitude less than that corresponding to the first triggering threshold (S1), the detection subunit (310) being furthermore configured to detect an electromagnetic pulse on each detection of the passage of the amplitude of the digital signal through the second stopping threshold (S2) in a falling edge after the amplitude of the digital signal has passed through the first triggering threshold (S 1) in a rising edge.

2. Detection and measurement unit (30) according to claim 1, wherein the detection and measurement unit (30) further comprises a temporal pulse(s) duration measurement subunit (320) communicating with the detection subunit (310), the temporal pulse(s) duration measurement subunit (320) being configured to measure the pulse duration(s) between the passages by the amplitude of the digital signal (501) of the first triggering threshold (S 1) in a rising edge and the passage of the second stopping threshold (S2) in a falling edge.

3. Detection and measurement unit (30) according to claim 1 or 2, wherein the detection subunit (310) comprises:

- a first comparator (311) adapted to compare the amplitude of the representative digital signal (501) with the first triggering threshold (S1), the first comparator (311) having a first state (E1) when the amplitude of the digital signal is less than, or is less than or equal to, the first triggering threshold (S1) and a second state (E2) otherwise,
- a second comparator (312) adapted to compare the amplitude of the representative digital signal (501) with the second stopping threshold (S2), the second comparator (312) having a third state (E3) when the amplitude of the representative digital signal is greater than, or is greater than or equal to, the second stopping threshold (S2) and a fourth state (E4) otherwise,

- a first latch (314) having a first latch input connected to the first comparator (311) and a second latch input connected to the second comparator (312), the first latch (314) being configured to switch from a fifth state (E5) to a sixth state (E6) when the first comparator has the second state (E2) , and to switch from the sixth state (E6) to the fifth state (E5) when the second comparator (312) has the fourth state (E4),

- a pulse counter (316) connected to an output of the first latch (314) and configured to count a pulse each time the first latch (314) switches from a state chosen from the sixth state (E6) and the fifth state (E5) to the other state from the sixth state (E6) and the fifth state (E5).

**4.** Detection and measurement unit (30) according to claims 2 and 3, wherein the temporal pulse(s) duration measurement subunit (320) comprises:

- a first clock (321) configured for have in alternation a seventh state (E7) and an eighth state (E8) with a first predefined alternating frequency,

- a first logic gate (323) having a first gate input connected to an output of the first latch (314) and a second gate input connected to the first clock (321), the first logic gate being configured to have a ninth state (E9) when the first latch (314) has the sixth state (E6) and when the clock (321) has the seventh state (E7), the first logic gate (323) having a tenth state (E10) the rest of the time,

- a pulse(s) duration counter connected to an output of the first logic gate (323) and configured to count a first clock pulsation each time the first logic gate has the ninth state (E9), the number of alternations counted corresponding to the pulse(s) duration.

**5.** Detection and measurement unit (30) according to any of the claims 1 to 4, further comprising a maximum pulse amplitude measurement subunit (330) capable of measuring a maximum amplitude level reached by the representative digital signal (501).

**6.** Detection and measurement unit (30) according to claim 5, wherein the maximum pulse amplitude measurement subunit (330) comprises a plurality of comparison units each comprising a third comparator and respective latch,

the third comparator of each comparison unit being adapted to compare the amplitude of the digital signal with a respective third triggering threshold which is distinct from the third triggering thresholds of the other third comparators, said third comparator having an eleventh state, when the amplitude of the representative digital signal is less than, or is less than or equal to, the corresponding third triggering threshold and a twelfth state otherwise,

the third latch of each comparison unit having a third latch input connected to the third comparator of said comparison unit, said third latch being configured to switch from a thirteenth state to a fourteenth state when the third comparator of said comparison unit has the twelfth state, the comparison units being configured so that the third triggering thresholds of the third comparators are distributed across a range of expected amplitudes for the digital signal.

**7.** Detection and measurement unit (30) according to any of the claims 1 o 6, further comprising an electromagnetic pulse repeat period measurement subunit (350).

**8.** Detection and measurement unit (30) according to claims 3 and 7, taken alone or in combination with any of claims 4 to 5, wherein the electromagnetic pulse repeat period measurement subunit (350) comprises:

- a frequency divider (351) configured to switch between a fifteenth state (E15) and sixteenth state (E16) on each switch of the first latch (314) to a given state chosen from the fifth state (E5) and the sixth state (E6),

- a double-period number counter (357) connected to an output of the frequency divider (357) and configured to count a double-period each time the frequency divider (351) switches from a state (0,1) chosen from the fifteenth state (E15) and the sixteenth state (E16) to the other state from the fifteenth state (E15) and the sixteenth state (E16),

- a second clock (353) configured for have in alternation a seventeenth state (E17) and an eighteenth state (E15) with a second predefined alternating frequency,

- a second logic gate (355) having a third gate input connected to an output of the frequency divider (351) and a fourth gate input connected to the second clock (353), the second logic gate (355) being configured to have a nineteenth state (E19) when the frequency divider (351) has the fifteenth state (E15) and when the second clock (353) has the seventeenth state (E1), the logic gate having a twentieth state (E20) the rest of the time,

- a period duration counter connected to an output of the second logic gate (355) and configured to count a second clock pulsation each time the frequency divider (351) switches from a state (0,1) chosen from the fifteenth state (E15) and the sixteenth state (E16) to the other state (0,1) from the fifteenth state (E15) and the sixteenth state (E16).

9. Detection and measurement unit according to claim 8, further comprising a buffer memory (358) configured to retrieve the value of the period duration counter on each switch of the frequency divider (351) from the sixteenth state (E16) to the fifteenth state (E15).

10. Detection and measurement unit (30) according to any of claims 1 to 9, wherein the detection subunit (310) is configured to receive a reset signal and to carry out, on receiving this reset signal, a supply of a number of electromagnetic pulses detected since a previous reset and a reset to zero of a counting of the number of electromagnetic pulses.

11. Detection and measurement unit (30) according to claims 2, 5 and 7 taken in combination, wherein the detection subunit (310), the temporal pulse(s) duration measurement subunit (320), the maximum pulse amplitude measurement subunit (330) and the electromagnetic pulse repeat period measurement subunit (350), are configured to receive a reset signal and to carry out, on receiving this reset signal:

- a supply respectively of a number of electromagnetic pulses detected, a temporal pulse(s) duration, a measured maximum pulse amplitude, and a number of electromagnetic pulses measured since a previous reset and
- a reset to zero of a counting of the number of electromagnetic pulses.

12. Electromagnetic interference detection system (1) comprising:

- a unit for receiving electromagnetic signals configured to receive at least a portion of an electromagnetic radiation to which the detection system is subjected in the form of an electromagnetic wave received in a given frequency band and to supply a digital signal representative of the envelope of said electromagnetic wave,
- a detection and measurement unit according to any of claims 1 to 11.

13. Analysis method for detecting electromagnetic interference carried out using a programmable logic circuit which was previously programmed to act as a detection subunit, the method comprising the steps of:

- receiving a digital signal representative of the envelope of an electromagnetic wave received in a given frequency band, in which an electromagnetic interference is susceptible to appear,
- comparing the amplitude of the representative digital signal with a first triggering threshold and a second stopping threshold, the second stopping threshold corresponding to an amplitude less than that corresponding to the first triggering threshold,
- detecting an electromagnetic pulse on each detection of the passage of the amplitude of the representative digital signal through the second threshold in a falling edge after the amplitude of the representative digital signal has passed through the first stopping threshold in a rising edge.

14. Analysis method for detecting electromagnetic interference according to claim 13, further comprising the steps of:

- supplying a first clock signal having a first predefined alternating frequency,
- modulating the first clock signal with an electromagnetic pulse detection signal supplied during the step of detecting an electromagnetic pulse,

counting the remaining clock signal number after modulation with the electromagnetic pulse detection signal.

FIG. 1

Art antérieur

FIG. 2

FIG. 3A

FIG. 3B

FIG. 4

FIG. 5

FIG. 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20170212161 A
- US 2014080417 A1
- US 5514987 A
- EP 3157181 B1